# FASCICULE DE BREVET EUROPEEN

(11) **EP 1 562 859 B1**
(45) Date de publication et mention de la délivrance du brevet: **26.01.2011**
(21) Numéro de dépôt: 03786062.4
(22) Date de dépôt: 20.11.2003
(51) Int. Cl.: C01F 7/42, C30B 11/12, C30B 11/00

(54) **PROCEDE DE PREPARATION D'ALUMINES HYDRATEES MONOLITHIQUES ET DE MATERIAUX COMPOSITES**
VERFAHREN ZUR HERSTELLUNG VON MONOLITHISCHEM HYDRATISIERTEN ALUMINIUMOXID UND VERBUNDMATERIALEN
METHOD FOR PREPARING MONOLITHIC HYDRATED ALUMINAS AND COMPOSITE MATERIALS

(30) Priorité: 21.11.2002 FR 0214579
(43) Date de publication de la demande: 17.08.2005
(73) Titulaire: Commissariat à l'Énergie Atomique et aux Énergies Alternatives, 75015 Paris (FR); CENTRE NATIONAL DE LA RECHERCHE SCIENTIFIQUE (CNRS), 75794 Paris Cedex 16 (FR)
(72) Inventeur: Beauvy, Michel, 13490 Jouques (FR); Vignes, Jean-Louis, 94240 l'Hay les Roses (FR); Michel, Daniel, 75013 Paris (FR); Mazerolles, Léo, 91600 Savigny sur Orge (FR); Frappart, Claude, 75012 Paris (FR); Di Costanzo, Thomas, 35000 Rennes (FR)
(74) Mandataire: Poulin, Gérard
(86) Numéro de dépôt international: PCT/FR2003/050126
(87) Numéro de publication internationale: WO 2004/048270

(56) Documents cités:
- MARKEL E J ET AL: "Aerogel monoliths produced by direct oxidation of aluminum" JOURNAL OF NON-CRYSTALLINE SOLIDS, NORTH-HOLLAND PHYSICS PUBLISHING. AMSTERDAM, NL, vol. 180, no. 1, 1 décembre 1994 (1994-12-01), pages 32-39, XP004067837 ISSN: 0022-3093 cité dans la demande
- RAM S ET AL: "Synthesis of mesoporous clusters of AlO(OH).alphaH2O by a surface hydrolysis reaction of pure Al-metal with nascent-surface in water" MATERIALS LETTERS, NORTH HOLLAND PUBLISHING COMPANY. AMSTERDAM, NL, vol. 42, no. 1-2, janvier 2000 (2000-01), pages 52-60, XP004256318 ISSN: 0167-577X
- NAKAGAWA ET AL: "Crystallisation of amorphous alumina prepared by hydration of Al-amalgam 120:168027j" CHEMICAL ABSTRACTS + INDEXES, AMERICAN CHEMICAL SOCIETY. COLUMBUS, US, vol. 120, no. 14, 4 avril 1994 (1994-04-04), page 235 XP000860419 ISSN: 0009-2258
- RAM ET AL: "Thermal desorption process of water in amorphous AlOOH . alpha H2O fibres prepared by an electrochemical method." MATERIAL TRANSACTIONS JIM, vol. 39, no. 4, 1998, pages 485-491, XP008021365

## Description

### DOMAINE TECHNIQUE

La présente invention a trait à un procédé de préparation d'une alumine hydratée ultraporeuse, se présentant sous forme de monolithes, ladite alumine servant, en autres, de produit de base pour la préparation d'alumines anhydres amorphes ou cristallisées, d'aluminates et de matériaux composites monolithiques.

### ETAT DE LA TECHNIQUE ANTERIEURE

Le domaine général de l'invention est donc celui de la préparation des alumines.

De nombreuses méthodes de préparation d'alumines par oxydation de l'aluminium à l'air existent dans l'art antérieur.

Ainsi, dès 1908, H.Wislicenus dans la référence [1] : Kolloid-Z, 2, 1908, 11 décrit l'utilisation de mercure pur déposé sur une pièce en aluminium ou alliage d'aluminium, afin d'obtenir de l'alumine sous forme de filaments ou de poudres. En revanche, cette méthode ne permet pas d'obtenir de l'alumine sous forme monolithique, c'est-à-dire sous forme de blocs poreux.

Plus récemment, dans la référence [2] : J.Markel et al dans J.of non Crystaline Solids, 180 (1994), 32 ont décrit un procédé de fabrication de monolithes d'alumine hydratée, comprenant une étape de dépôt de mercure sur une surface en aluminium, ledit mercure étant obtenu par réduction d'ions mercuriques, dans une solution d'acide nitrique. Cette solution permet dans un premier temps de dissoudre la couche de passivation présente sur la surface d'aluminium et ensuite de former un amalgame avec le mercure. Cet amalgame protège la pièce d'aluminium du phénomène de passivation de l'aluminium par l'oxygène et catalyse la réaction de formation d'alumine, par réaction des ions aluminium à l'air libre.

Toutefois, la méthode exposée ci-dessus permet tout au plus d'obtenir une croissance monolithique d'alumine de quelques millimètres, à condition d'effectuer, en plus, une évacuation énergétique de la chaleur dégagée par la réaction.

### EXPOSÉ DE L'INTENTION

Le but de la présente invention est donc de proposer un procédé de préparation d'une alumine hydratée monolithique, ledit procédé permettant d'assurer une croissance efficace de l'alumine à partir d'une pièce en aluminium ou en un alliage d'aluminium.

D'autres buts de la présente invention sont également de proposer des procédés de préparation d'alumines anhydres amorphes ou cristallisées, d'aluminates et de matériaux composites monolithiques à partir d'alumines hydratées préparées selon l'invention.

Pour ce faire, l'invention a trait à un procédé de préparation d'une alumine hydratée monolithique, ledit procédé comprenant successivement les étapes suivantes :
a) décapage d'une surface d'une pièce en aluminium ou en un alliage d'aluminium ;
b) recouvrement de ladite surface par un amalgame de mercure comprenant au moins un métal noble ; et
c) exposition de ladite surface recouverte obtenue en b) à une atmosphère oxydante humide.

Selon l'invention, on précise que, dans ce qui précède et ce qui suit, par surface, on entend 'au moins une partie' de ladite pièce.

On note que, selon l'invention, l'étape de décapage est destinée à éliminer la couche passive d'oxydation présente éventuellement sur la surface de la pièce en aluminium ou alliage d'aluminium et peut être mise en oeuvre, par exemple, par nettoyage de la surface à l'aide d'un solvant, afin d'éliminer les matières organiques éventuellement déposées sur ladite surface, ce nettoyage pouvant être suivi d'un décapage mécanique de la couche d'alumine (dite couche passive d'oxydation), par exemple, par abrasion d'eau.

Le procédé permet avantageusement d'obtenir un monolithe d'alumine hydratée ultraporeux, pouvant présenter, selon les conditions expérimentales, une masse volumique de 0,01 à 0,05 g.cm⁻³.

Il est également possible avec ce procédé, selon l'invention, de former des monolithes, dont la section et la forme correspondent à celles de la surface de la pièce en aluminium ou en un alliage d'aluminium, qui sert de base pour le dépôt de l'amalgame et dont la hauteur dudit monolithe est contrôlée uniquement par la durée imposée à la croissance.

Selon le procédé de l'invention, on peut également assurer un contrôle de la croissance monolithique, en récupérant par exemple le produit formé lorsqu'il atteint une hauteur souhaitée ou en laissant se poursuivre la réaction jusqu'à consommation complète de l'aluminium ou de l'alliage d'aluminium constitutif de la pièce, ce qui n'était pas possible pour les réalisations de l'art antérieur. Ainsi, avec ledit procédé, l'on peut obtenir, dans le cas d'une oxydation complète de l'aluminium, une hauteur de monolithe pouvant atteindre, par exemple, près de 1000 fois l'épaisseur de la pièce d'aluminium de départ.

De plus, la structure spongieuse des alumines hydratées monolithiques obtenues par le procédé permet d'absorber des quantités importantes de fluides, et permet également d'effectuer des échanges physico-chimiques ou thermiques avec des phases gazeuses, par exemple, l'air ambiant.

On peut ainsi récupérer, au sein des monolithes hydratés des liquides anhydres tels que des huiles ou divers produits polluants ou pollués. Par échange avec des phases gazeuses, on peut, par exemple, fixer et ainsi éliminer de l'air ambiant des vapeurs acides ou basiques ou divers autres polluants.

De préférence, le procédé selon l'invention comporte, en outre, une étape de refroidissement de la surface de la pièce en aluminium ou en alliage d'aluminium, ladite étape étant mise en oeuvre simultanément à l'étape d'exposition c. En effet, pour assurer une croissance correcte du monolithe, il est préférable de limiter la température de l'aluminium ou alliage d'aluminium à des valeurs maximales de l'ordre de 40-50 °C, et de préférence, à des températures proches de la température ambiante. Or, les réactions d'hydratation et d'oxydation, se produisant au cours de l'étape d'exposition, sont fortement exothermiques et dégagent une chaleur importante, ce qui peut gêner le bon déroulement du procédé. Le refroidissement de la surface traitée par l'amalgame peut, ainsi, avantageusement être effectuée par l'intermédiaire d'un système d'évacuation de chaleur, par exemple par circulation d'un liquide réfrigérant, ledit système étant relié directement à la surface recouverte obtenue à l'étape b. Le refroidissement peut également s'effectuer par fixation de la surface en aluminium ou alliage d'aluminium à un bloc métallique refroidi par une circulation d'eau provenant d'un cryostat. Néanmoins, il est préférable de ne pas refroidir à une température trop basse, afin d'éviter une condensation de l'humidité de l'atmosphère oxydante humide.

Selon un mode particulier de réalisation de l'invention, le procédé peut comporter, en outre, afin d'améliorer la croissance monolithique, au moins une étape de régénération de la surface recouverte d'amalgame, ladite étape de régénération consistant à éliminer l'amalgame précédemment déposée puis à redéposer un amalgame tel que défini précédemment et exposer à nouveau la surface nouvellement recouverte à une atmosphère oxydante humide.

Par exemple, l'élimination de l'amalgame de la surface s'effectue par un traitement mécanique ou chimique tel qu'un lavage acide, qui va éliminer l'amalgame comprenant des impuretés présentes éventuellement sur ladite surface.

Ce mode de réalisation est particulièrement avantageux, lorsque la surface de la pièce en aluminium ou alliage d'aluminium comporte des impuretés, telles que du fer, du cuivre ou du silicium, lesquelles impuretés qui peuvent contribuer à bloquer prématurément la croissance monolithique, lorsque la teneur de ces impuretés est supérieure à quelques centaines de parties par million dans l'aluminium ou alliage d'aluminium. Le traitement de régénération peut consister à éliminer les espèces impures présentes à l'interface entre la surface de base et l'amalgame par un traitement approprié, tel qu'un lavage acide. Un tel lavage va supprimer l'amalgame contaminé, qui ne permet plus d'assurer une croissance correcte de l'alumine. L'élimination doit être suivie d'un nouveau dépôt d'amalgame, pour redémarrer la croissance monolithique à partir de la surface réactivée.

De préférence, la surface en aluminium est une surface ayant une teneur en aluminium de 99,99 à 99,999% en masse.

Avantageusement, l'utilisation d'un aluminium d'une telle teneur, dans le cadre de ce procédé, assure une croissance monolithique sans ralentissement, du fait de la présence infime d'impuretés au niveau de ce matériau.

Selon l'invention, la surface en aluminium peut être une surface en alliage d'aluminium comprenant, par exemple, environ 1% de magnésium.

L'utilisation d'un tel alliage n'entrave pas la croissance monolithique d'alumine, du fait que le magnésium, selon les conditions opératoires appliquées, s'oxyde sans gêner l'oxydation de l'aluminium.

L'amalgame de mercure, utilisé dans le cadre de l'invention, est un amalgame de mercure comprenant au moins un métal noble.

Par métal noble, on entend, selon l'invention, un métal qui ne s'oxyde ni à l'air ni à l'eau et que les acides attaquent très difficilement.

Selon l'invention, le métal noble compris dans l'amalgame peut être choisi dans un groupe constitué par l'argent, l'or, le palladium, le platine, le rhodium, l'iridium, le ruthénium et les mélanges de ceux-ci.

De préférence, le métal noble, utilisé dans l'amalgame à base de mercure, est l'argent. L'utilisation d'un tel métal est particulièrement avantageuse, car il s'agit d'un métal noble peu onéreux, en particulier sous sa forme nitrate, qui donne, de plus, d'excellents résultats, dans le cadre de ce procédé.

Selon l'invention, la teneur en argent de l'amalgame de mercure peut aller de 1 à 43% atomique d'argent, de préférence est sensiblement égale à 40%.

La teneur optimale en métal noble de l'amalgame pour obtenir une vitesse de croissance monolithique et une densité du monolithe données peut être déterminée aisément par l'homme du métier.

Selon l'invention, l'étape de recouvrement de la surface en aluminium ou alliage d'aluminium par l'amalgame peut s'envisager selon plusieurs possibilités.

Selon une première possibilité, l'étape de recouvrement peut être réalisée par dépôt direct de l'amalgame sous forme liquide sur la surface à recouvrir. Cette variante nécessite une préparation préalable de l'amalgame avant dépôt. Cet amalgame est préparé, par exemple, par mélange de mercure liquide et d'une quantité déterminée de métal noble solide.

Selon une deuxième possibilité, l'étape de recouvrement peut être réalisée par dépôt d'un sel de mercure et d'au moins un sel de métal noble directement sur la surface, l'amalgame se formant directement sur ladite surface, par une réaction d'oxydoréduction. Généralement, les sels de mercure et du métal noble choisi se présentent sous forme de solutions de nitrate de mercure et du métal noble choisi. Par exemple, ces solutions ont une concentration en mercure de 0,05 à 0,1 mol/l et en métal noble, tel que l'argent, de 0,001 à 0,03 mol/L.

Selon cette deuxième possibilité, soit le dépôt s'effectue en deux étapes, par exemple, en trempant successivement la surface à recouvrir dans une solution de sel de mercure puis dans une solution de sel de métal noble ou soit en une seule étape, par exemple, en plongeant la surface à recouvrir dans une solution contenant les deux sels. Il est à noter que, selon ces deux alternatives, l'amalgame de mercure à base de métal noble se forme directement sur la surface en aluminium ou alliage d'aluminium.

Selon un mode particulièrement avantageux de l'invention, l'atmosphère oxydante, dans laquelle se déroule la fabrication d'alumine hydratée, selon l'invention, est de l'air. Ainsi, la fabrication d'alumine peut s'effectuer, selon ce mode de réalisation, directement à l'air libre, sans qu'il faille recourir à une atmosphère oxydante aménagée.

De préférence, le taux d'humidité de l'atmosphère oxydante va de 20 à 99,99%. Un tel taux permet d'assurer une réaction d'hydratation correcte, dans la mesure où la vitesse de croissance du monolithe est sensiblement proportionnelle au taux d'humidité. Pour bénéficier d'un tel taux d'humidité, le degré d'hygrométrie habituel des climats tempérés peut être tout à fait satisfaisant. Toutefois, par temps très sec, la proximité d'un récipient d'eau ouvert peut fournir une humidité suffisante. Si l'on souhaite assurer des conditions de croissance contrôlées rigoureusement, il est possible de réguler le degré hygrométrique, par exemple, en utilisant une enceinte climatique ou tout dispositif similaire.

La température, à laquelle l'étape d'exposition c) peut être réalisée, peut être sensiblement la température ambiante. Il est entendu, toutefois, que cette température ne doit pas être, de préférence, trop basse, afin d'éviter la condensation de l'humidité atmosphérique.

L'on obtient ainsi à l'issue du procédé selon l'invention une alumine hydratée monolithique, constituée d'une phase, dont la composition est voisine de Al₂O₃-4H₂O. Cette alumine est ultra-légère, de masse volumique pouvant être comprise entre 1.10⁻² et 5.10⁻²g.cm⁻³ et de porosité pouvant être supérieure à 99% et de grande surface spécifique pouvant aller de 300 à plus de 400 m².g⁻¹.

Du point de vue structural, l'alumine hydratée obtenue selon le procédé de l'invention, comporte un ensemble de fibres enchevêtrées nanostructurées d'un diamètre moyen, par exemple, d'environ 5 nanomètres, de telle sorte à former un monolithe. Outre les interstices entre les fibres, qui forment une porosité de direction aléatoire, l'alumine peut comporter, selon l'invention, une autre porosité formée par des canaux de quelques micromètres de diamètre moyen, lesdits canaux étant parallèles entre eux et orientés selon la direction de croissance du matériau.

La présente invention a également pour objet des procédés de fabrication d'alumines anhydres amorphes ou d'alumines anhydres cristallisées monolithiques à partir d'alumines hydratées obtenues selon le procédé décrit précédemment.

Ainsi, on peut préparer, à partir d'une alumine hydratée obtenue selon le procédé décrit précédemment, une alumine anhydre amorphe monolithique par chauffage de ladite alumine hydratée à une température adéquate, c'est-à-dire une température permettant d'obtenir la déshydratation de l'alumine hydratée de départ.

On peut préparer également, selon l'invention, une alumine monolithique cristallisée sous forme d'alumine δ, γ, θ, κ, κ', ou α par chauffage de l'alumine hydratée précitée à une température adéquate. On entend, dans ce cas, par température adéquate, une température permettant d'obtenir la phase cristalline en question. Cette température peut être déterminée aisément par l'homme du métier par des techniques, telles que l'analyse par diffraction des rayons X, la température adéquate étant choisie lorsque les pics relatifs à la phase cristalline voulue apparaissent sur le diagramme par diffraction des rayons X.

Généralement, la température de chauffage pour obtenir des alumines anhydres peut être, par exemple, de 200 à environ 850°C pour une alumine amorphe, d'environ 850 à environ 1100°C pour une alumine γ, d'environ 1100°C à environ 1200 °C pour une alumine θ, supérieure à 1200°C pour une alumine α.

On peut obtenir ainsi une alumine cristallisée sous sa forme γ dont la masse volumique peut aller de 10.10⁻² à 50.10⁻² g.cm⁻³, avec une porosité élevée de l'ordre de 90% et une surface spécifique pouvant aller de 100 à plus de 150 m²/g.

On peut obtenir ainsi une alumine cristallisée sous sa forme α dont la masse volumique peut aller de 20.10⁻² à 200.10⁻² g.cm⁻³, avec une porosité allant de 10 à 80%.

Toutefois, la masse volumique et la porosité du monolithe, pour les diverses alumines anhydres présentées ci-dessus, dépendent de la température et du temps de chauffage, ces traitements thermiques s'accompagnant d'une diminution des dimensions du monolithe, tout en conservant la forme du produit de départ. Ces paramètres peuvent être aisément fixés, par l'homme de l'art, en fonction des critères recherchés.

Grâce à ces procédés, on obtient ainsi des alumines monolithiques poreuses amorphes ou cristallisées sous différentes formes allotropiques, lesdites alumines ayant une structure poreuse similaire au produit de départ, dans la mesure où la structure poreuse de l'alumine hydratée de départ subsiste lors des traitements thermiques. Il est à noter également, qu'avec la température de chauffage, la taille des grains constitutifs de l'alumine augmente de même que la densité, alors que la surface spécifique diminue. Ces alumines cristallisées ultraporeuses peuvent être imprégnées par une phase liquide ou gazeuse. On peut ainsi insérer en leur sein diverses espèces chimiques telles que des oxydes, des polymères, des produits carbonés ou des métaux divisés, et les soumettre à un éventuel traitement thermique, pour former par exemple, des catalyseurs, des isolants thermiques ou phoniques, des matrices de confinements nucléaires ou de transmutation de radioéléments, des matériaux réfractaires à propriétés spécifiques, de fenêtres transparentes au rayonnement infrarouge, des membranes de filtration.

Les procédés de préparation d'alumines de type γ ou θ, dites « alumines de transition », peuvent comporter une étape supplémentaire précédant l'étape de chauffage, ladite étape supplémentaire étant destinée à assurer une stabilisation desdites alumines cristallisées, notamment à des températures de 1200 à 1430°C, domaine de température où habituellement la phase α se forme. Cette stabilisation permet, en outre, de conserver à ces températures des fibres ou des particules de taille nanométrique.

Ainsi, le procédé de fabrication d'alumines cristallisées de type explicité ci-dessus, c'est-à-dire de type γ ou θ, peut comporter, en outre, avant l'étape de chauffage, une étape préliminaire d'exposition de l'alumine hydratée préparée selon le procédé de l'invention explicité ci-dessus à des vapeurs d'au moins un précurseur d'oxyde à une température sensiblement ambiante.

Par exemple, ces précurseurs d'oxydes peuvent être des précurseurs de silice, tels que le tétraéthoxysilane, le triméthyléthoxysilane. On peut obtenir ainsi pour ces alumines de transition, après chauffage, un taux de silice de 2 à 3% en masse, contribuant ainsi à stabiliser lesdites alumines.

Le procédé de fabrication d'alumines cristallisées δ, γ, θ, κ, κ' ou α peut comporter, en outre, avant l'étape de chauffage, une étape d'exposition de l'alumine hydratée à des vapeurs acides ou basiques à une température sensiblement ambiante. Par exemple, les vapeurs acides sont des vapeurs d'acide chlorhydrique.

Les vapeurs basiques peuvent être des vapeurs ammoniaquées.

Le traitement par des vapeurs acides ou basiques se traduit par l'apparition de chlorure d'aluminium hydraté avec l'acide chlorhydrique ou d'hydroxyde d'aluminium avec l'ammoniac. Ces traitements contribuent à modifier les températures d'apparition de diverses phases d'alumine. Par exemple, après traitement acide, les variétés d'alumines de transition κ et κ' apparaissent entre 800 et 980°C et la phase α se forme dès 1000°C. Par exemple, après traitement ammoniaqué, la variété δ est obtenue entre 800 et 1000°C, la variété θ à environ 1000°C. Après chauffage des monolithes traités par l'ammoniac, à des températures de 300 à 800°C, la surface spécifique augmente fortement pour atteindre des valeurs de 400 m².g⁻¹ avec une surface microporeuse de plus de 100 m².g⁻¹. Cette microporosité importante est intéressante, notamment pour des applications en catalyse.

La présente invention a également pour objet un procédé de préparation d'un aluminate monolithique, préparé à partir d'alumines hydratées, d'alumines anhydres amorphes et/ou anhydres cristallisées obtenues selon l'un des procédés explicités ci-dessus.

On précise que, selon l'invention, on entend par aluminate un oxyde comportant, dans son réseau cristallin, en plus de l'oxygène au moins deux éléments métalliques dont l'aluminium.

Ce procédé comporte successivement :
d) une étape d'imprégnation d'une alumine avec au moins un composé comprenant un ou plusieurs éléments métalliques à introduire dans l'alumine, pour former l'aluminate, ladite alumine étant préparée par un des procédés précédemment décrits ; et
e) une étape de décomposition par chauffage du composé introduit en d) suivie d'une étape de formation de l'aluminate par chauffage.

Le composé choisi peut être, par exemple, le tétraéthoxysilane, pour former des aluminosilicates tels que la mullite (par exemple de formule 2SiO₂-3Al₂O₃). Le composé choisi peut être des sels d'éléments métalliques pour former, par exemple, des spinelles, tels que ceux répondant à la formule MgAl₂O₄ ou pour former des grenats, tels que ceux répondant à la formule Y₃Al₅O₁₂.

Selon l'invention, le sel d'élément métallique peut être choisi dans un groupe constitué par les nitrates ou chlorures de magnésium, de titane, de fer, de cobalt, de cuivre, de nickel, d'yttrium, d'actinides, de lanthanides, et les mélanges de ceux-ci.

Les températures adéquates nécessaires d'une part à la décomposition des composés comprenant le ou les éléments métalliques à introduire dans l'alumine et d'autre part à l'introduction du ou desdits éléments métalliques dans le réseau de l'alumine, afin de former l'aluminate peuvent être déterminées aisément par l'homme du métier par diffraction des rayons X, comme cela a déjà été explicité ci-dessus.

Par exemple, l'étape de décomposition du composé comprenant le ou les éléments métalliques à introduire dans l'alumine pour former l'aluminate, s'effectue à l'air à une température sensiblement égale à 500°C et l'étape de formation de l'aluminate consistant en une introduction dans le réseau de l'alumine des éléments métalliques libérés par la décomposition dudit composé, peut s'effectues à l'air, par exemple, par chauffage à une température allant de 700 à 1400°C.

De tels aluminates trouvent leurs applications dans de nombreux domaines, tels que l'isolation thermique ou phonique, la catalyse, le stockage de déchets nucléaires ou l'élaboration de cibles de transmutation de radioéléments, les matériaux réfractaires à propriétés spécifiques, les fenêtres transparentes au rayonnement infrarouge, les membranes.

La présente invention a également pour objet la préparation de matériaux composites à base d'alumines amorphes et/ou cristallisées et/ou d'aluminates, préparés selon les procédés explicités ci-dessus.

Ainsi, selon l'invention, le procédé de préparation d'un matériau composite comprenant une alumine et/ou un aluminate tel que préparé précédemment et au moins un autre composé et/ou élément comprend successivement les étapes suivantes :
f) une étape d'imprégnation de l'alumine et/ou de l'aluminate avec au moins un précurseur du ou des autres composés et/ou élément(s) ;
g) une étape de formation dudit ou desdits composé(s) et/ou élément(s), le ou les composé(s) et/ou élément(s) formant à l'issue de cette étape avec l'alumine et/ou l'aluminate le matériau composite.

L'autre composé pouvant former un matériau composite avec une alumine et/ou un aluminate obtenus selon un procédé de l'invention, peut être choisi dans un groupe constitué par les céramiques, les métaux, les polymères et les mélanges de ceux-ci.

Un élément pouvant former un matériau composite avec une alumine et/ou un aluminate obtenus selon un procédé de l'invention peut être du carbone élémentaire, ledit carbone élémentaire pouvant être choisi dans un groupe constitué par le graphite, le carbone pyrolytique, le carbone vitreux et les mélanges de ceux-ci.

A titre d'exemples, le précurseur de composé, lorsque l'autre composé est une céramique, peut être un sel d'élément métallique choisi dans un groupe constitué par le métatungstate de sodium, d'ammonium, l'oxychlorure de zirconium, le nitrate de calcium, d'yttrium, d'actinides, de lanthanides, de magnésium, de cuivre, de fer, de cobalt, de nickel, l'oxalate de diammonium titanyle, le chlorure de titane, de baryum et les mélanges de ceux-ci.

Généralement l'étape de formation de la céramique correspondante à ces sels, peut être réalisée, à l'air, par chauffage desdits précurseurs à une température de 400°C à 800°C. Ce chauffage sert, d'une part, à décomposer les sels, libérant ainsi des éléments métalliques et d'autre part à oxyder lesdits éléments métalliques. Par exemple, lorsque le sel est l'oxychlorure de zirconium, l'étape de chauffage permet d'obtenir une céramique de type zircone ZrO₂. Cette céramique forme ainsi avec l'alumine et/ou l'aluminate un matériau composite.

De tels matériaux composites peuvent trouver leur application dans de nombreux domaines, tels que l'isolation thermique ou phonique, la catalyse, le stockage des déchets nucléaires ou l'élaboration de cibles de transmutation de radioéléments, les matériaux réfractaires à propriétés spécifiques, les fenêtres transparentes au rayonnement infrarouge, les membranes.

A titre d'exemples, le précurseur de composé, lorsque l'autre composé est un métal, peut être un sel d'élément métallique choisi dans un groupe constitué par les nitrates de fer, de cobalt, de cuivre, de nickel, de plomb, d'étain, de zinc, de tungstène, de molybdène, le métatungstate de sodium, d'ammonium, les sels de métaux nobles (argent, or, palladium, platine, rhodium, iridium, ruthénium) et les mélanges de ceux-ci.

L'étape de formation du métal, entrant dans la composition du matériau composite, comprend une étape de décomposition du ou des sels d'élément métallique s'effectuant à l'air à une température sensiblement égale à 500°C moyennant quoi on obtient à l'issue de cette étape l'oxyde métallique correspondant à l'élément métallique ou à une température de 800 à 1200°C, suivi d'une étape de réduction par chauffage dudit oxyde métallique pour obtenir le métal.

Lorsque l'étape de décomposition est effectuée dans une gamme de température de 800 à 1200°C, l'on peut former un aluminate pur, par réaction entre l'alumine et l'oxyde métallique formé, notamment de structure spinelle ou un mélange d'oxydes métallique et d'aluminate ou d'alumine et d'aluminate en fonction des rapports molaires alumine/oxydes insérés.

L'étape de réduction, destinée à assurer la réduction de l'oxyde métallique provenant du sel ou de l'aluminate éventuellement formé, peut s'envisager par action d'un réducteur choisi dans un groupe constitué par l'hydrogène ou le monoxyde de carbone, à une température adéquate allant, de préférence, de 500 à 1200°C.

L'avantage procuré par un tel procédé est qu'on accède à des matériaux composites notamment par traitement à des températures moins élevées que celles habituellement requises pour réaliser la réaction à l'état solide avec des poudres classiques. En effet, notamment en raison des dimensions nanométriques des grains constitutifs des alumines préparées selon l'invention, ces dernières présentent une réactivité extrêmement élevée.

De tels matériaux composites peuvent trouver leur application dans de nombreux domaines, tels que la catalyse, le magnétisme, notamment pour des applications hautes fréquences et plus généralement, toute propriété induite par la dispersion de fines particules métalliques sur un matériau solide stable chimiquement ou thermiquement.

En ce qui concerne les matériaux composites selon l'invention avec des polymères, le précurseur de polymère peut être un monomère ou un mélange de monomères, l'étape de formation du polymère étant une étape classique de polymérisation.

A titre d'exemples, on peut citer comme monomère un monomère choisi dans un groupe constitué par le styrène, l'aniline, l'isoprène, l'éthylène, le chlorure de vinyle, le butadiène et les mélanges de ceux-ci.

En ce qui concerne les matériaux composites selon l'invention avec du carbone élémentaire, le précurseur dudit carbone peut être un hydrocarbure, l'étape de formation de carbone élémentaire consistant en un craquage thermique.

On précise que, selon l'invention, par carbone élémentaire, on entend du carbone pouvant être sous la forme de graphite, de carbone pyrolytique, de carbone amorphe, de carbone vitreux et des mélanges de ceux-ci.

De tels matériaux peuvent trouver leur application dans de nombreux domaines tels que le renforcement et la stabilisation des matières plastiques, l'isolation thermique ou phonique, la catalyse, les applications des nanotubes ou fibres tels que ceux de carbone.

L'invention va maintenant être décrite en référence aux exemples suivants donnés à titre illustratif et non limitatif.

### EXPOSÉ DÉTAILLÉ DE MODES DE RÉALISATION PARTICULIERS

### EXEMPLE 1.

Cet exemple illustre la préparation d'une alumine monolithique hydratée.

Le matériau de départ est une plaque d'aluminium pur à 99,99% de 1 mm d'épaisseur.

Dans un premier temps, la surface métallique est préparée par nettoyage avec un solvant (acétone, alcool) ou une lessive, afin d'éliminer les matières organiques et par décapage mécanique par abrasion sous courant d'eau de la couche de passivation d'alumine. La surface est ensuite rincée à l'eau permutée et maintenue recouverte par une pellicule d'eau.

Dans un deuxième temps, la surface ainsi préparée est recouverte par un amalgame de mercure liquide contenant 40% atomique d'argent en frottant la surface par l'amalgame liquide préalablement préparé.

Enfin, la surface recouverte est fixée sur un bloc métallique refroidi par une circulation d'eau à 15°C provenant d'un cryostat. La surface est exposée à l'air atmosphérique avec un taux d'humidité de 50% à la température ambiante de 20°C. La réaction d'oxydation démarre immédiatement par l'apparition instantanée d'une couche translucide visible à l'oeil après quelques secondes. Cette couche continue ensuite de croître sous forme d'un monolithe perpendiculairement à la plaque d'aluminium à une vitesse de 5 mm à l'heure. Après quatre jours de croissance, on obtient un monolithe de près d'un mètre. Il répond à la formule Al₂O₃.4H₂O.

### EXEMPLE 2.

Cet exemple illustre également la préparation d'une alumine monolithique hydratée, selon un autre mode de réalisation.

Le matériau de départ est une plaque d'aluminium pur à 99,99% de 1 mm d'épaisseur.

Dans un premier temps, la surface métallique est nettoyée à l'aide d'un solvant comme dans l'exemple 1, afin d'éliminer les matières organiques puis plongée dans une solution acide ou basique, telle qu'une solution de soude ou d'acide chlorhydrique, pendant quelques minutes pour éliminer la couche d'alumine passivante puis est rincée à l'eau permutée ou distillée sans séchage ultérieur.

Dans un deuxième temps, la surface d'aluminium est trempée successivement pendant quelques minutes dans une solution de sel de mercure, plus précisément une solution de nitrate de mercure ayant une concentration comprise entre 0,05 et 0,1 mol/L puis dans une solution de sel d'argent, plus précisément de nitrate d'argent de concentration comprise entre 0,001 et 0,03 mol/L.

L'étape d'exposition est réalisée dans les mêmes conditions que dans l'exemple 1.

On obtient à l'issue de cet exemple une alumine monolithique hydratée de formule globale Al₂O₃.4H₂O.

### EXEMPTE 3.

Cet exemple illustre la préparation d'une alumine monolithique hydratée, selon un autre mode de réalisation.

On suit le même mode opératoire que dans l'exemple 2, sauf que l'étape de recouvrement par l'amalgame de mercure liquide se déroule en une seule étape, par trempage de la surface à traiter dans une solution contenant les deux sels.

On obtient à l'issue de cet exemple une alumine monolithique hydratée de formule globale Al₂O3.4H₂O.

### EXEMPLE 4.

Cet exemple illustre la préparation de monolithes nanométriques d'alumine amorphe anhydre.

Dans cet exemple, on utilise comme produit de départ l'alumine hydratée préparée selon l'exemple 1, 2 ou 3. On chauffe ladite alumine à une température de 200 à 870°C.

### Exemple 5.

Cet exemple illustre la préparation de monolithes d'alumine γ.

Dans cet exemple, on utilise comme produit de départ l'alumine hydratée préparée selon l'exemple 1, 2, ou 3.
On chauffe ladite alumine à l'air à des températures comprises entre 870°C et 1100°C, pour obtenir une alumine monolithique cristallisée sous forme γ.

### EXEMPLE 6.

Cet exemple illustre la préparation de monolithes d'alumine θ.

Dans cet exemple, on utilise comme on utilise comme produit de départ l'alumine hydratée préparée selon l'exemple 1, 2, 3.

On chauffe ladite alumine à l'air à des températures comprises entre 1100°C et 1200°C, pour obtenir une alumine monolithique cristallisée sous forme θ.

### EXEMPLE 7.

Cet exemple illustre la préparation de monolithes d'alumine α.
Dans cet exemple, on utilise comme produit de départ l'alumine hydratée préparée selon l'exemple 1, 2 ou 3.

On chauffe ladite alumine à l'air à des températures supérieures à 1200 °C, pour obtenir une alumine monolithique cristallisée sous forme α.

### EXEMPLE 8.

Cet exemple illustre la préparation de monolithes d'alumines γ ou θ stabilisées.

Dans cet exemple, on utilise comme produit de départ l'alumine hydratée préparée selon les exemples 1 ou 2 ou 3. On met ce produit en présence de vapeurs de triméthyléthoxysilane (TMES) dans un récipient clos ou à l'aide d'une circulation continue des vapeurs de TMES. La durée de traitement, réalisé à une température proche de la température ambiante, est de 10 à 120 minutes.

Après élimination de l'excès de TMES par séchage à l'étuve à 100 °C, les alumines sont calcinées à des températures comprises entre 870°C et 1420°C.

Pour des chauffages de 870 à 1300°C, on obtient la phase γ. La phase θ est obtenue par des chauffages de 1300°C à 1420°C. Les alumines monolithiques θ ainsi obtenues peuvent subir, sans dommage, les conditions de préparation habituelles des catalyseurs et en particulier l'imprégnation par des solutions aqueuses en maintenant l'intégrité du monolithe. Ces monolithes contiennent de 3 à 10% en masse de silice.

### EXEMPLE 9.

Cet exemple illustre la préparation de monolithes d'aluminates par exemple de mullite.

Dans cet exemple, on utilise comme matériau de départ l'alumine hydratée préparée selon l'exemple 1, 2 ou 3. On met ce produit en présence de vapeurs de tétraéthoxysilane (TEOS) dans un récipient clos ou à l'aide d'une circulation continue de vapeurs de TEOS. La durée de traitement, réalisé à une température proche de la température ambiante est comprise entre 1 et 6 jours.

Après élimination de l'excès de TOES par séchage à l'étuve de 100°C, les monolithes sont calcinés à des températures comprises entre 980 et 1400°C, pour obtenir l'aluminate adéquat.

### EXEMPLE 10.

Cet exemple illustre la préparation de monolithes d'aluminates, par exemple, d'aluminate de magnésium de structure spinelle.

Dans cet exemple, on utilise comme matériau de départ une alumine préparée selon l'exemple 6, 7 ou 8. Le matériau de départ est imprégné par une solution aqueuse de nitrate de magnésium par immersion dudit matériau dans ladite solution ou par infiltration de ladite solution dans ledit matériau. Le contrôle de la concentration de la solution de sel et du nombre d'imprégnations permet d'obtenir la stoechiométrie souhaitée pour obtenir le composé MgAl₂O₄.

L'alumine ainsi imprégnée est ensuite chauffée à une température de 700 à 1000°C afin de décomposer le sel métallique et de former, par insertion des éléments Mg dans le réseau de l'alumine, le composé de structure spinelle.

### EXEMPLE 11.

Cet exemple illustre la préparation de monolithes d'un matériau composite alumine ou aluminate avec un composé céramique, comme par exemple de l'oxyde de zirconium stabilisé avec de l'yttrium.

Dans cet exemple, on utilise comme produit de départ une alumine ou un aluminate préparé selon l'exemple 6, 7, 8, 9 ou 10. Le matériau de départ est imprégné par une solution aqueuse d'oxychlorure de zirconium et de chlorure d'yttrium par immersion dudit matériau dans ladite solution ou par infiltration de ladite solution dans ledit matériau. Le contrôle de la concentration de la solution de sels et du nombre d'imprégnations permet d'obtenir la composition souhaitée en oxyde. Celle-ci peut varier de moins de 1% à plus de 80% en masse.

L'alumine ou aluminate ainsi imprégné(e) est ensuite chauffé(e) à une température comprise entre 700 et 1300°C afin de décomposer le sel métallique et de former la zircone stabilisée.

### EXEMPLE 12.

Cet exemple illustre la préparation d'un matériau composite d'alumine ou d'aluminate (contenant éventuellement un autre oxyde) avec un métal par exemple le nickel.

Dans cet exemple, on utilise comme matériau de base une alumine ou un aluminate préparé selon l'exemple 6, 7, 8, 9, 10.

L'alumine ou aluminate est imprégné(e) par une solution de nitrate de nickel par immersion de ladite alumine ou aluminate (contenant éventuellement un autre oxyde dans ladite solution ou par infiltration de ladite solution au sein de l'alumine ou de l'aluminate ou du composite avec un autre oxyde.

Le contrôle de la concentration de la solution de sel et du nombre d'imprégnation permet d'obtenir la stoechiométrie souhaitée. Celle-ci peut varier de moins de 1% à plus de 80% en masse de métal contenu dans le composite.

L'alumine ainsi imprégnée est ensuite chauffée à une température de 400 à 500°C afin de décomposer le sel métallique, puis subit une réduction sous H₂ ou CO à une température de 500 à 800°C.

### EXEMPLE 13.

Cet exemple illustre la préparation d'un matériau composite d'alumine ou d'aluminate (contenant éventuellement un autre oxyde et/ou un métal) avec un polymère, tel que le polystyrène.

Dans cet exemple, on utilise comme matériau de base une alumine ou un aluminate selon l'exemple 6, 7, 8, 9, 10. Le matériau de base est imprégné par du styrène liquide. Celui-ci a été préparé par lavage par une solution d'hydroxyde de sodium, rinçage, séchage puis ajout de peroxyde de benzoyle. La polymérisation du matériau est effectuée dans une étuve à 80°C pendant plus de 24 heures.

### EXEMPLE 14.

Cet exemple illustre la préparation d'un matériau composite d'alumine ou d'aluminate (contenant éventuellement un autre oxyde et/ou un métal) avec un produit carboné, par exemple des nanotubes de carbone.

Dans cet exemple, on utilise comme matériau de base une alumine ou un aluminate ou un composite préparé selon les exemples 6, 7, 8, 9, 10, 11 ou 12. Le matériau de base est traité par un gaz tel que l'acétylène, l'éthylène, le propylène ou le méthane qui, par craquage par chauffage entre 500 et 1200°C donne des nanotubes de carbone.

### Références bibliographiques

[1] : Kolloid-Z, 2, 1908, 11
[2] : J.Markel et al dans J.of non Crystaline Solids, 180 (1994), 32

## Revendications

1. Procédé de préparation d'une alumine hydratée monolithique, ledit procédé comprenant successivement les étapes suivantes :
a)décapage d'une surface d'une pièce en aluminium ou en un alliage d'aluminium ;
b) recouvrement de ladite surface par un amalgame de mercure comprenant au moins un métal noble ; et
c) exposition de ladite surface recouverte obtenue en b) à une atmosphère oxydante humide.

2. Procédé de préparation selon la revendication 1, comprenant, en outre, une étape de refroidissement de ladite surface, ladite étape étant mise en oeuvre simultanément à l'étape d'exposition c).

3. Procédé de préparation selon la revendication 2, dans lequel l'étape de refroidissement est réalisée par l'intermédiaire d'un système d'évacuation de chaleur relié directement à la surface obtenue en b).

4. Procédé de préparation selon l'une quelconque des revendications 1 à 3, comprenant, en outre, au moins une étape de régénération de la surface recouverte d'amalgame, ladite étape de régénération consistant à éliminer l'amalgame précédemment déposée puis à redéposer un amalgame tel que défini dans la revendication 1 et exposer à nouveau la surface nouvellement recouverte à une atmosphère oxydante humide.

5. Procédé de préparation selon l'une quelconque des revendications 1 à 4, **caractérisé en ce que** la surface en aluminium est une surface ayant une teneur en aluminium de 99,99 à 99,999% en masse.

6. Procédé de préparation selon l'une quelconque des revendications 1 à 5, dans lequel le métal noble inclus dans l'amalgame est choisi dans un groupe constitué par l'argent, l'or, le palladium, le platine, le rhodium, l'iridium, le ruthénium et les mélanges de ceux-ci.

7. Procédé de préparation selon la revendication 6, dans lequel le métal noble est l'argent.

8. Procédé de préparation selon la revendication 7, dans lequel l'amalgame de mercure présente un teneur en argent allant de 1 à 43% atomique d'argent, de préférence égale à sensiblement 40%.

9. Procédé de préparation selon l'une quelconque des revendications 1 à 8, dans lequel l'étape de recouvrement b) est réalisée par dépôt direct de l'amalgame sous forme liquide sur la surface à recouvrir.

10. Procédé de préparation selon l'une quelconque des revendications 1 à 8, dans lequel l'étape de recouvrement est réalisée par dépôt d'un sel de mercure et d'au moins un sel de métal noble directement sur la surface, l'amalgame se formant directement sur ladite surface.

11. Procédé de préparation selon l'une quelconque des revendications 1 à 10, dans lequel l'atmosphère oxydante est de l'air.

12. Procédé de préparation selon l'une quelconque des revendications 1 à 11, dans lequel l'atmosphère oxydante humide est telle qu'elle présente un taux d'humidité allant de 20% à 99,99%.

13. Procédé de préparation selon l'une quelconque des revendications 1 à 12, dans lequel l'étape d'exposition c) s'effectue sensiblement à température ambiante.

14. Procédé de préparation d'une alumine anhydre amorphe monolithique, comportant une étape de chauffage à une température adéquate, de l'alumine hydratée préparée par un procédé selon l'une quelconque des revendications 1 à 13.

15. Procédé de préparation d'une alumine monolithique cristallisée sous forme δ, γ, θ, κ, κ' ou α comprenant une étape de chauffage à une température adéquate de l'alumine hydratée préparée par un procédé selon l'une quelconque des revendications 1 à 13.

16. Procédé de préparation selon la revendication 15, comportant, lorsque l'alumine est du type γ ou θ, avant l'étape de chauffage, une étape d'exposition de l'alumine hydratée préparée par un procédé selon l'une quelconque des revendications 1 à 13, à des vapeurs d'au moins un précurseur d'oxyde à une température sensiblement ambiante.

17. Procédé de préparation selon la revendication 16, dans lequel le, au moins un, précurseur d'oxyde est un précurseur de silice.

18. Procédé de préparation selon la revendication 17, dans lequel le, au moins un, précurseur de silice est choisi dans un groupe constitué par le tétraéthoxysilane, le triméthyléthoxysilane.

19. Procédé de préparation selon la revendication 15, comportant, en outre, lorsque l'alumine est du type δ, γ, θ, K, κ' ou α, avant l'étape de chauffage, une étape d'exposition de l'alumine hydratée préparée par un procédé selon l'une quelconques des revendications 1 à 13 à des vapeurs acides ou basiques à une température sensiblement ambiante.

20. Procédé de préparation selon la revendication 19, dans lequel les vapeurs acides sont des vapeurs d'acide chlorhydrique.

21. Procédé de préparation selon la revendication 19, dans lequel les vapeurs basiques sont des vapeurs ammoniaquées.

22. Procédé de préparation d'un aluminate monolithique, comprenant successivement :
d) une étape d'imprégnation d'une alumine avec au moins un composé comprenant un ou plusieurs éléments métalliques à introduire dans ladite alumine, pour former l'aluminate, ladite alumine étant préparée par un procédé selon l'une quelconque des revendications 1 à 21 ; et
e) une étape de décomposition par chauffage dudit composé introduit en d) suivie d'une étape de formation de l'aluminate par chauffage.

23. Procédé de préparation selon la revendication 22, dans lequel le composé comprenant le ou les éléments métalliques à introduire est le tétraéthoxysilane.

24. Procédé de préparation selon la revendication 22, dans lequel le composé comprenant le ou les éléments métalliques à introduire est un sel d'élément métallique choisi dans un groupe constitué par les nitrates ou chlorures de magnésium, de titane, de fer, de cobalt, de cuivre, de nickel, d'yttrium, d'actinides, de lanthanides, et les mélanges de ceux-ci.

25. Procédé de préparation selon l'une quelconque des revendications 22 à 24, dans lequel l'étape de décomposition du composé choisi s'effectue à l'air par chauffage à une température sensiblement égale à 500°C.

26. Procédé de préparation selon l'une quelconque des revendications 22 à 25, dans lequel l'étape de formation de l'aluminate s'effectue à l'air par chauffage à une température allant de 700 à 1400°C.

27. Procédé de préparation d'un matériau composite comprenant une alumine et/ou un aluminate, et au moins un autre composé et/ou élément, ladite alumine étant obtenue par un procédé selon l'une quelconque des revendications 1 à 21, ledit aluminate étant obtenu par un procédé selon l'une quelconque des revendications 22 à 26, ledit procédé comprenant successivement les étapes suivantes :
f) une étape d'imprégnation de l'alumine et/ou de l'aluminate avec au moins un précurseur dudit ou desdits autre(s) composé(s) et/ou élément(s);
g) une étape de formation dudit ou desdits composé(s) et/ou élément(s), le ou les composé(s) et/ou élément(s) formant à l'issue de cette étape avec l'alumine et/ou l'aluminate le matériau composite.

28. Procédé de préparation selon la revendication 27, dans lequel l'autre composé est choisi dans un groupe constitué par les céramiques, les métaux, les polymères et les mélanges de ceux-ci.

29. Procédé de préparation selon la revendication 27, dans lequel l'élément est du carbone élémentaire.

30. Procédé de préparation selon la revendication 29, dans lequel le carbone élémentaire est choisi dans un groupe constitué par le graphite, le carbone pyrolytique, le carbone vitreux et les mélanges de ceux-ci.

31. Procédé de préparation selon la revendication 28, dans lequel, lorsque l'autre composé est une céramique, le précurseur de ce composé est un sel d'élément métallique choisi dans un groupe constitué par le métatungstate de sodium, d'ammonium, l'oxychlorure de zirconium, le nitrate de calcium, d'yttrium, d'actinides, de lanthanides, de magnésium, de cuivre, de fer, de cobalt, de nickel, l'oxalate de diammonium titanyle, le chlorure de titane, de baryum et les mélanges de ceux-ci.

32. Procédé de préparation selon la revendication 28 ou 31, dans lequel l'étape de formation de la céramique s'effectue, à l'air, par chauffage desdits précurseurs à une température de 400 à 800°C.

33. Procédé de préparation selon la revendication 28, dans lequel, lorsque l'autre composé est une métal, le précurseur de ce composé est un sel d'élément métallique choisi dans un groupe constitué par les nitrates de fer, de cobalt, de cuivre, de nickel, de plomb, d'étain, de zinc, de tungstène, de molybdène, le métatungstate de sodium, d'ammonium, les sels de métaux nobles (argent, or, palladium, platine, rhodium, iridium, ruthénium) et les mélanges de ceux-ci.

34. Procédé de préparation selon la revendication 33, dans lequel l'étape de formation du métal comprend une étape de décomposition du ou des sels d'élément métallique s'effectuant à l'air à une température sensiblement égale à 500°C ou à une température de 800 à 1200°C, moyennant quoi on obtient à l'issue de cette étape un oxyde métallique, suivi d'une étape de réduction par chauffage dudit oxyde métallique pour obtenir le métal.

35. Procédé de préparation selon la revendication 34, dans lequel l'étape de réduction s'effectue par action d'un réducteur choisi dans un groupe constitué par l'hydrogène, le monoxyde de carbone, à une température adéquate allant, de préférence, de 500 à 1200°C.

36. Procédé de préparation selon la revendication 28, dans lequel, lorsque l'autre composé est un polymère, le précurseur de ce composé est un monomère ou un mélange de monomères.

37. Procédé de préparation selon la revendication 36, dans lequel le monomère est choisi dans un groupe constitué par le styrène, l'aniline, l'isoprène, l'éthylène, le chlorure de vinyle, le butadiène et les mélanges de ceux-ci.

38. Procédé de préparation selon les revendications 36 ou 37, dans lequel l'étape de formation du polymère consiste en une étape de polymérisation.

39. Procédé de préparation selon la revendication 29 ou 30, dans lequel, lorsque l'élément est du carbone élémentaire, le précurseur de cet élément est un hydrocarbure.

40. Procédé de préparation selon la revendication 39, dans lequel l'étape de formation du carbone élémentaire consiste en un craquage thermique.

## Claims

1. Method of preparation of a monolithic hydrated alumina, the said method comprising, in succession, the following steps:
a) abrading of a surface of a part made of aluminium or an aluminium alloy;
b) covering of the said surface with a mercury amalgam comprising at least one noble metal; and
c) exposure of the said covered surface obtained at b) to a wet oxidizing atmosphere.

2. Method of preparation according to Claim 1, which furthermore includes a step of cooling the said surface, the said step being carried out simultaneously with the exposure step c).

3. Method of preparation according to Claim 2, in which the cooling step is carried out by means of a heat extraction system connected directly to the surface obtained at b).

4. Method of preparation according to any one of Claims 1 to 3, which furthermore includes at least one step of regenerating the surface covered with amalgam, the said regeneration step consisting in removing the amalgam previously deposited and then in redepositing an amalgam, as defined in Claim 1, and in again exposing the newly covered surface to a wet oxidizing atmosphere.

5. Method of preparation according to any one of Claims 1 to 4, **characterized in that** the aluminium surface is a surface having an aluminium content of 99.99 to 99.999% by weight.

6. Method of preparation according to any one of Claims 1 to 5, in which the noble metal included in the amalgam is chosen from the group consisting of silver, gold, palladium, platinum, rhodium, iridium, ruthenium and mixtures thereof.

7. Method of preparation according to Claim 6, in which the noble metal is silver.

8. Method of preparation according to Claim 7, in which the mercury amalgam has a silver content ranging from 1 to 43 at%, preferably substantially equal to 40 at%, silver.

9. Method of preparation according to any one of Claims 1 to 8, in which the covering step b) is carried out by direct deposition of the amalgam in liquid form on the surface to be covered.

10. Method of preparation according to any one of Claims 1 to 8, in which the covering step is carried out by depositing a mercury salt and at least one noble metal salt directly on the surface, the amalgam forming directly on the said surface.

11. Method of preparation according to any one of Claims 1 to 10, in which the oxidizing atmosphere is air.

12. Method of preparation according to any one of Claims 1 to 11, in which the wet oxidizing atmosphere is such that it has a relative humidity ranging from 20% to 99.99%.

13. Method of preparation according to any one of Claims 1 to 12, in which the exposure step c) is carried out substantially at ambient temperature.

14. Method of preparation of a monolithic amorphous anhydrous alumina, which includes a step of heating the hydrated alumina prepared by a method according to any one of Claims 1 to 13 to an appropriate temperature.

15. Method of preparation of a monolithic alumina crystallized in the δ, γ, θ, κ, κ', or α form, which includes a step of heating the hydrated alumina prepared by a method according to any one of Claims 1 to 13 to an appropriate temperature.

16. Method of preparation according to Claim 15, which includes, when the alumina is of the γ or θ type, before the heating step, a step of exposing the hydrated alumina prepared by a method according to any one of Claims 1 to 13 to the vapour of at least one oxide precursor at a substantially ambient temperature.

17. Method of preparation according to Claim 16, in which the, or at least one, oxide precursor is a silica precursor.

18. Method of preparation according to Claim 17, in which the, or at least one, silica precursor is chosen from the group consisting of tetraethoxysilane and trimethylethoxysilane.

19. Method of preparation according to Claim 15, which further includes, when the alumina is of the δ, γ, θ, κ, κ', or α type, before the heating step, a step of exposing the hydrated alumina prepared by a method according to any one of Claims 1 to 13 to the vapour of an acid or base at a substantially ambient temperature.

20. Method of preparation according to Claim 19, in which the acid vapour is hydrochloric acid vapour.

21. Method of preparation according to Claim 19, in which the base vapour is ammonia vapour.

22. Method of preparation of a monolithic aluminate, which comprises in succession:
d) a step of impregnating an alumina with at least one compound containing one or more metal elements to be introduced into the said alumina, in order to form the aluminate, the said alumina being produced by a method according to any one of Claims 1 to 21; and
e) a step of decomposing the said compound introduced at d) by heating it, followed by a step of forming the aluminate by heating.

23. Method of preparation according to Claim 22, in which the compound comprising the metal element or elements to be introduced is tetraethoxysilane.

24. Method of preparation according to Claim 22, in which the compound comprising the metal element or elements to be introduced is a metal salt chosen from the group consisting of magnesium, titanium, iron, cobalt, copper, nickel, yttrium, actinide and lanthanide nitrates or chlorides, and mixtures thereof.

25. Method of preparation according to any one of Claims 22 to 24, in which the step of decomposing the compound chosen is carried out in air by heating to a temperature substantially equal to 500°C.

26. Method of preparation according to any one of Claims 22 to 25, in which the step of forming the aluminate is carried out in air by heating to a temperature ranging from 700 to 1400°C.

27. Method of preparation of a composite material comprising an alumina and/or an aluminate and at least one other compound and/or element, the said alumina being obtained by a method according to any one of Claims 1 to 21 and the said aluminate being obtained by a method according to any one of Claims 22 to 26, the said method comprising in succession, the following steps:
f) a step of impregnating the alumina and/or the aluminate with at least one precursor of the said other compound(s) and/or element(s); and
g) a step of forming the said compound(s) and/or element(s), the compound(s) and/or element(s) forming with the alumina and/or the aluminate, after this step, the composite material.

28. Method of preparation according to Claim 27, in which the other compound is chosen from a group consisting of ceramics, metals, polymers and mixtures thereof.

29. Method of preparation according to Claim 27, in which the element is elemental carbon.

30. Method of preparation according to Claim 29, in which the elemental carbon is chosen from the group consisting of graphite, pyrolytic carbon, glassy carbon and mixtures thereof.

31. Method of preparation according to Claim 28, in which, when the other compound is a ceramic, the precursor of this compound is a metal salt chosen from the group consisting of sodium metatungstate, ammonium metatungstate, zirconium oxychloride, calcium, yttrium, actinide, lanthanide, magnesium, copper, iron, cobalt and nickel nitrates, diammonium titanyl oxalate, titanium and barium chlorides, and mixtures thereof.

32. Method of preparation according to Claim 28 or 31, in which the step for forming the ceramic is produced, in air, by heating the said precursors to a temperature of between 400°C and 800°C.

33. Method of preparation according to Claim 28, in which, when the other compound is a metal, the precursor of this compound is a metal salt chosen from the group consisting of iron, cobalt, copper, nickel, lead, tin, zinc, tungsten and molybdenum nitrates, sodium metatungstate, ammonium metatungstate, salts of noble metals (silver, gold, palladium, platinum, rhodium, iridium, ruthenium), and mixtures thereof.

34. Method of preparation according to Claim 33, in which the step for forming the metal comprises a step of decomposing the metal salt or salts, which is carried out in air at a temperature substantially equal to 500°C or at a temperature of 800 to 1200°C, by means of which a metal oxide is obtained after this step, followed by a reduction step, by heating the said metal oxide in order to obtain the metal.

35. Method of preparation according to Claim 34, in which the reduction step is carried out by the action of a reducing agent chosen from the group consisting of hydrogen and carbon monoxide, at a suitable temperature, preferably ranging from 500 to 1200°C.

36. Method of preparation according to Claim 28, in which, when the other compound is a polymer, the precursor of this compound is a monomer or a monomer mixture.

37. Method of preparation according to Claim 36, in which the monomer is chosen from the group consisting of styrene, aniline, isoprene, ethylene, vinyl chloride, butadiene and mixtures thereof.

38. Method of preparation according to Claim 36 or 37, in which the step for forming the polymer consists of a polymerization step.

39. Method of preparation according to Claim 29 or 30, in which, when the element is elemental carbon, the precursor of this element is a hydrocarbon.

40. Method of preparation according to Claim 39, in which the step for forming the elemental carbon consists of a thermal cracking step.

## Patentansprüche

1. Verfahren zur Herstellung eines hydratisierten monolithische Aluminiumoxid, welches Verfahren nacheinander die folgenden Schritte umfasst:
a) Dekapieren einer Oberfläche eines Werkstücks aus Aluminium oder aus einer Aluminiumlegierung;
b) Bedecken der Oberfläche mit einem Quecksilberamalgam, das wenigstens ein Edelmetall enthält; und
c) Exponieren der in b) erhaltenen bedeckten Oberfläche an eine oxidierende feuchte Atmosphäre.

2. Herstellungsverfahren nach Anspruch 1, ferner umfassend einen Schritt des Abkühlens der Oberfläche, weicher Schritt gleichzeitig mit dem Exponierschritt c) durchgeführt wird

3. Herstellungsverfahren nach Anspruch 2, bei dem der Schritt des Abkühlens mittels eines Wärmeabfuhrsystems realisiert wird, das direkt mit der in b) erhaltenen Oberfläche verbunden ist.

4. Herstellungsverfahren nach einem der Ansprüche 1 bis 3, ferner umfassend wenigstens einen Schritt der Regeneration der mit Amalgam bedeckten Oberfläche, wobei der Regenerationsschritt darin besteht, das vorher aufgebrachte Amalgam zu entfernen, dann erneut ein Amalgam aufzubringen, wie es in Anspruch 1 definiert ist, und die erneut bedeckte Oberfläche erneut an eine oxidierende feuchte Atmosphäre zu exponieren.

5. Herstellungsverfahren nach einem der Ansprüche 1 bis 4, **dadurch gekennzeichnet, dass** die Aluminiumoberfläche eine Oberfläche ist, die einen Aluminiumgehalt von 99,99 bis 99,999 Masse % hat.

6. Herstellungsverfahren nach einem der Ansprüche 1 bis 5, bei dem das im Amalgam enthaltene Edelmetall ausgewählt ist aus der Gruppe gebildet durch Silber, Gold, Palladium, Platin, Rhodium, Iridium, Ruthenium und Mischungen derseiben.

7. Herstellungsverfahren nach Anspruch 6, bei dem das Edelmetall Silber ist.

8. Herstellungsverfahren nach Anspruch 7, bei dem das Quecksilberamalgam einen Silbergehalt aufweist, der von 1 bis 43 Atom % Silber reicht, vorzugsweise im Wesentlichen gleich 40 %.

9. Herstellungsverfahren nach einem der Ansprüche 1 bis 8, bei dem der Bedeckungsschritt b) durch direktes Aufbringen des Amalgams in flüssiger Form auf der zu bedeckenden Oberfläche realisiert wird.

10. Herstellungsverfahren nach einem der Ansprüche 1 bis 8, bei dem der Bedeckungsschritt durch Aufbringen eines Quecksilbersalzes und wenigstens eines Edelmetallsalzes direkt auf der Oberfläche realisiert wird, wobei sich das Amalgam direkt auf der Obefläche bildet.

11. Herstellungsverfahren nach einem der Ansprüche 1 bis 10, bei dem die oxidierende Atmosphäre Luft ist.

12. Herstellungsverfahen nach einem der Ansprüche 1 bis 11, bei dem die oxidierende feuchte Atmosphäre derart gewählt ist, dass sie eine Feuchtigkeitsrate zwischen 20 % und 99,99 % aufweist.

13. Herstellungsverfahren nach einem der Ansprüche 1 bis 12, bei dem der Exponierschritt c) im Wesentlichen bei Umgebungstemperatur durchgeführt wird.

14. Verfahren zur Herstellung eines wasserfreie amorphen monolithischen Aluminiumoxids, umfassend einen Schritt des Aufheizens des hydratisierten Aluminiums, das mittels eines Verfahrens nach einem der Ansprüche 1 bis 13 hergestellt wurde, auf eine adäquate Temperatur.

15. Verfahren zur Herstellung eines monolithischen kristallisierten Aluminiumoxids in der Form δ, γ, θ, κ, κ' oder α, umfassend einen Schritt des Aufheizens des mittels eines Verfahrens nach einem der Ansprüche 1 bis 13 hergestellten hydratisierten Aluminiumoxids auf eine adäquate Temperatur.

16. Herstellungsverfahren nach Anspruch 15, umfassend, wenn das Aluminiumoxid vom Typ γ oder θ ist, vor dem Schritt des Aufheizens einen Schritt des Exponierens des hydratisierten Aluminiumoxids, das mittels eines Verfahrens nach einem der Ansprüche 1 bis 13 hergestellt wurde, an Dämpfe wenigstens eines Oxidprecursors bei im Wesentlichen Umgebungstemperatur.

17. Herstellungsverfahren nach Anspruch 16, bei dem der wenigstens eine Oxidprecursor ein Siliziumoxidprecursor ist.

18. Herstellungsverfahren nach Anspruch 17, bei dem der wenigstens eine Siliziumoxidprecursor ausgewählt ist aus einer Gruppe gebildet durch Tetraethoxysilan und Trimethylethoxysilan.

19. Herstellungsverfahren nach Anspruch 15, ferner umfassend, wenn das Aluminiumoxid vom Typ δ, γ, θ, κ, κ' oder α ist, vor dem Schritt des Aufheizens einen Schritt des Exponierens des mittels eines Verfahrens nach einem der Ansprüche 1 bis 13 hergestellten hydratisierten Aluminiumoxids an saure oder basische Dämpfe bei im Wesentlichen Umgebungstemperatur.

20. Herstellungsverfahren nach Anspruch 19, bei dem die sauren Dämpfe Salzsäuredämpfe sind.

21. Herstellungsverfahren nach Anspruch 19, bei dem die basischen Dämpfe Ammoniakdämpfe sind.

22. Verfahren zur Herstellung eines monolithischen Aluminats, umfassend nacheinander:
d) einen Schritt des Imprägnierens eines Aluminiumoxids mit wenigstens einer Verbindung, die ein oder mehrere metallische Elemente enthält, die in das Aluminiumoxid einzudringen sind, um das Aluminat zu bilden, wobei das Aluminiumoxid mittels eines Verfahrens nach einem der Ansprüche 1 bis 21 hergestellt wird; und
e) einen Schritt der Heiz-Zerlegung der in d) eingebrachten Verbindung, gefolgt durch einen Schrit der Bildung des Aluminats durch Heizen.

23. Herstellungsverfahren nach Anspruch 22, bei dem die Verbindung, die das oder die einzubringenden metallischen Elemente enthält, Tetraethoxysilan ist.

24. Herstellungsverfahren nach Anspruch 22, bei dem die Verbindung, die das oder die einzubringenden metallischen Elemente enthält, ein Salz eines metallischen Elements ist, ausgewählt aus der Gruppe gebildet durch die Nitrate oder Chloride von Magnesium, Titan, Eisen, Kobalt, Kupfer, Nickel, Yttrium, Aktiniden, Lanthaniden, sowie den Mischungen derselben.

25. Herstellungsverfahren nach einem der Ansprüche 22 bis 24, bei dem der Schritt der Zerlegung der gewählten Verbindung an Luft durch Heizen auf eine Temperatur im Wesentlichen gleich 500 °C durchgeführt wird.

26. Herstellungsverfahren nach einem der Ansprüche 22 bis 25, bei dem der Schritt der Bildung des Aluminats an Luft durch Heizen auf eine Temperatur zwischen 700 und 1400 °C durchgeführt wird.

27. Verfahren zur Herstellung eines Verbundmaterials, das ein Aluminumoxid und/oder ein Aluminat enthält, sowie wenigstens eine andere Verbindung und/oder Element, wobei das Aluminiumoxid mittels eines Verfahrens nach einem der Ansprüche 1 bis 21 erkalten wird, wobei das Aluminat mittels eines Verfahrens nach einem der Ansprüche 22 bis 26 erhalten wird, wobei das Verfahren nacheinander die folgenden Schritte umfasst:
f) einen Schritt des Imprägnierens des Aluminiumoxids und/oder des Aluminats mit wenigstens einem Precursor des/der andere(n) Verbindung(en) und/oder Element(e);
g) einen Schritt des Bildens des oder der Verbindung(en) und/oder Elements(e) wobei das oder die Verbindung(en) und/oder Element(e) am Ende dieses Schrittes mit dem Aluminiumoxid und/oder dem Aluminat das Verbundmaterial bilden.

28. Herstellungsverfahren nach Anspruch 27, bei dem die andere Verbindung ausgewählt ist aus der Gruppe gebildet durch die Keramiken, die Metalle, die Polymere und die Mischungen derselben.

29. Herstellungsverfahren nach Anspruch 27, bei dem das Element elementarer Kohlenstoff ist.

30. Herstellungsverfahren nach Anspruch 29, bei dem der elementare Kohlenstoff ausgewählt ist aus der Gruppe gebildet durch Graphit, pyrolytischen Kohlenstoff, glasartigen Kohlenstoff und die Mischungen derselben.

31. Herstellungsverfahren nach Anspruch 28, bei dem, wenn die andere Verbindung eine Keramik ist, der Precursor dieser Verbindung ein Salz eines metallischen Elements ist, ausgewählt aus der Gruppe gebildet durch das Metatungstat von Natrium, Ammonium, Zirkoniumoxichlorid, das Nitrat von Calcium, Yttrium, Aktiniden, Lanthaniden, Magnesium, Kupfer, Eisen, Kobalt, Nickel, Diammoniumtitanyloxalat, das Chlorid von Titan, Barium und den Mischungen derselben.

32. Herstellungsverfahren nach Anspruch 28 oder 31, bei dem der Schritt der Bildung der Keramik an Luft durch Aufheizen der Precursor auf eine Temperatur von 400 bis 800°C durchgeführt wird.

33. Herstellungsverfahren nach Anspruch 28, bei dem, wenn die andere Verbindung ein Metall ist, der Precursor dieser Verbindung ein Salz eines metallischen Elements ist, ausgewählt aus einer Gruppe gebildet durch die Nitrate von Eisen, Kobalt, Kupfer, Nickel, Blei, Zinn, Zink, Wolfram, Molybdän, das Metantungstat von Natrium, Ammonium, den Edelmetallsalzen (Silber, Gold, Paladium, Platin, Rhodium, Iridium, Ruthenium) und den Mischungen derselben.

34. Herstellungsverfahren nach Anspruch 33, bel dem der Schritt des Bildens des Metalls einen Schritt der Zerlegung des oder der Salze des metallischen Elements umfasst, welche an Luft bei einer Temperatur von im Wesentlichen gleich 500 °C oder bei einer Temperatur von 800 bis 1200 °C durchgeführt wird, wodurch man am Ende des Schrittes ein metallisches Oxid erhält, gefolgt von einem Schritt der Heiz-Reduktion des metallischen Oxids, um das Metall zu erhalten.

35. Herstellungsverfahren nach Anspruch 34, bei dem der Reduktionsschritt durch Winkung eines Reduktionsmittels durchgeführt wird, ausgewählt aus der Gruppe gebildet durch Wasserstoff, Kohlenstoffmonoxid, bei einer adäquaten Temperatur, die vorzugsweise zwischen 500 und 1200 °C liegt.

36. Herstellungsverfahren nach Anspruch 28, bei dem, wenn die andere Verbindung ein Polymer ist, der Precursor dieser Verbindung ein Monomer oder eine Mischung von Monomeren ist.

37. Herstellungsverfahren nach Anspruch 36, bei dem das Monomer ausgewählt ist aus der Gruppe gebildet durch Styrol, Anilin, Isopren, Ethylen, Venylchlorid, Butadien und den Mischungen derselben.

38. Herstellungsverfahren nach Anspruch 36 oder 37, bei dem der Schritt des Bildens des Polymers aus einem Polymerisationsschritt besteht.

39. Herstellungsverfahren nach Anspruch 29 oder 30, bei dem, wenn das Element elementarer Kohlenstoff ist, der Precursor diese Elements ein Kohlenwasserstoff ist.

40. Herstellungsverfahren nach Anspruch 39, bei dem der Schritt des Bildens des elementaren Kohlenstoffs aus thermischem Cracking besteht
